# EUROPÄISCHE PATENTSCHRIFT

(11) **EP 1 412 974 B1**
(45) Veröffentlichungstag und Bekanntmachung des Hinweises auf die Patenterteilung: **31.07.2019**
(21) Anmeldenummer: 02747220.8
(22) Anmeldetag: 14.06.2002
(51) Int. Cl.: H01L 21/50, H01L 23/10, H01L 23/552, H03H 3/08, H03H 9/10

(54) **VERFAHREN ZUR HERMETISCHEN VERKAPSELUNG EINES BAUELEMENTES**
METHOD FOR HERMETICALLY ENCAPSULATING A COMPONENT
PROCEDE D'ENCAPSULAGE HERMETIQUE D'UN COMPOSANT

(30) Priorität: 27.07.2001 DE 10136743
(43) Veröffentlichungstag der Anmeldung: 28.04.2004
(73) Patentinhaber: TDK Electronics AG, 81671 München (DE)
(72) Erfinder: STELZL, Alois, 81549 München (DE); KRÜGER, Hans, 81737 München (DE); FEIERTAG, Gregor, 80689 München (DE); CHRISTL, Ernst, 84137 Vilsbiburg (DE)
(74) Vertreter: Epping - Hermann - Fischer
(86) Internationale Anmeldenummer: PCT/DE2002/002188
(87) Internationale Veröffentlichungsnummer: WO 2003/012856

(56) Entgegenhaltungen:
- EP-A- 0 967 647
- EP-A- 1 091 406
- EP-A- 1 093 159
- DE-A- 3 138 743
- DE-A- 19 816 309
- US-A- 5 439 849
- US-A1- 2001 009 277

## Beschreibung

Ein Verfahren zur hermetischen Verkapselung eines Bauelementes ist beispielsweise aus der WO 99/43084 bekannt. Dort werden Bauelemente, insbesondere Oberflächenwellenbauelemente, auf einem mit lötbaren Anschlußflächen versehenen Träger in Flipchiptechnik aufgebracht. Dabei ist das Bauelement über Bumps (Lotkugeln) im lichten Abstand zum Träger so auf diesem aufgelötet, daß die Oberfläche mit den Bauelementstrukturen zum Träger weist. Zur hermetischen Verkapselung der auf dem Träger befindlichen Bauelemente werden diese schließlich mit einer Metallfolie oder einer metallbeschichteten Kunststoffolie auf dem Träger von der Rückseite her abgedeckt und verklebt oder laminiert. Die Folie schließt dabei zwischen den auf dem Träger aufgebrachten Bauelementen dicht mit dem Träger ab, so daß eine hermetische Verkapselung für die Bauelementstrukturen entsteht. Vorgeschlagen wird auch, die Verkapselung durch Umpressen oder Vergießen, z. B. mit Epoxidharz weiter zu stabilisieren und weiter hermetisch abzudichten. Anschließend können die Bauelemente durch Auftrennen der Trägerplatte vereinzelt werden.

Es hat sich herausgestellt, daß die Verwendung einer Metallfolie ebenso wie die Verwendung einer metallbeschichteten Kunststoffolie zur direkten Aufbringung auf die Rückseite des Bauelementes mit Problemen behaftet ist und zu Bauelementen führen kann, deren hermetische Abdichtung unbefriedigend ist.

Aus der EP 1 093 159 A1 ist ein Verfahren zur hermetischen Verkapselung bekannt, bei dem ein in Flip-Chip-Bauweise auf einem Substrat montierter Chip mittels einer verformbaren Folie verkapselt wird. Nach Entfernung der Folie außerhalb eines Randbereichs um den Chip kann darüber eine mineralische, hermetisch abdichtende Schicht abgeschieden werden.

Aufgabe der vorliegenden Erfindung ist es daher, ein Verfahren zur Herstellung einer hermetischen Verkapselung anzugeben, welches einfach durchzuführen ist, und in sicherer Weise zu einem hermetisch verkapselten Bauelement führt und eine weitere Miniaturisierung ermöglicht.

Diese Aufgabe wird erfindungsgemäß durch ein Verfahren mit den Merkmalen von Anspruch 1 gelöst. Vorteilhafte Ausgestaltungen der Erfindungen sowie vorteilhafte Anwendungen der Erfindung sind weiteren Ansprüchen zu entnehmen.

Die Erfindung schlägt vor, ein in Flip-Chip-Bauweise auf einem Träger aufgebrachtes Bauelement zunächst mit einer ersten Folie zu überdecken, diese im Randbereich um das Bauelement mit der Oberfläche des Trägers zu verbinden, die Folie anschließend zu strukturieren, und als letzten Schritt eine hermetisch abdichtende Schicht über der Folie so aufzubringen, daß sie außerhalb des Randbereiches hermetisch dicht mit dem Träger abschließt.

Durch die Auftrennung der Verkapselung in zwei unabhängig voneinander aufzubringende Schichten ist es möglich, die beiden Schritte unabhängig voneinander zu optimieren. Der erste Schritt kann dabei so angepaßt werden, daß die Folie im Zusammenwirken mit den Aufbringbedingungen dicht auf Bauelementrückseite und im Randbereich um das Bauelement herum auf dem Träger dicht aufliegt. In einem Zwischenschritt erfolgt die Strukturierung der Folie, wobei insbesondere eine Dimensionierung der abdeckenden Folie erfolgt, die die Größe des verkapselten Bauelementes festlegt. Des Weiteren wird bei der Strukturierung außerhalb des Randbereiches, diesen umfassend die Oberfläche des Trägers freigelegt, damit die hermetisch abdichtende Schicht dort in Kontakt mit dem Träger treten kann, um ein dichtes Abschließen mit dem Träger zu gewährleisten.

Die bereits dicht das Bauelement umschließende und auf dem Träger aufliegende Folie ermöglicht es, die hermetische Schicht in einer Vielzahl unterschiedlicher Verfahren aufzubringen. Da das Bauelement unter der Folie abgedeckt ist, sind auch isotrope Schichterzeugungsverfahren, naßchemische Verfahren, Gas- oder Dampfverfahren ebenso wie Plasmaverfahren einsetzbar. Bei geeignet ausgewählter Folie kann die hermetisch abdichtende Schicht auch als Schmelze aufgebracht werden. Im Vergleich zum bekannten Verfahren, bei dem beispielsweise eine metallbeschichtete Kunststoffolie als alleinige Abdeckung verwendet wird, wird bei erfindungsgemäßen Verfahren die Dichtigkeit durch die zwei unabhängig voneinander aufzubringenden Schichten bzw. Folien erheblich verbessert. Während das Aufbringen der Folie auf Formschlüssigkeit hin optimiert sein kann, kann die zweite Schicht auf die Dichtigkeit optimiert werden.

Ein formschlüssiges Aufbringen der Folie auf die Chiprückseite und den Träger gelingt erfindungsgemäß insbesondere mit einer thermoplastischen Folie. Diese läßt sich bei Aufbringung unter erhöhter Temperatur erweichen und unter Druck auf Chiprückseite und Oberfläche des Trägers auflaminieren. Das formschlüssige Aufbringen läßt sich durch Anlegen eines Unterdrucks zwischen Folie und Träger unterstützen.

Als thermoplastisches Material für die Folie sind insbesondere solche Materialien geeignet, die beständig gegen den Kontakt mit stromführenden Metalloberflächen sind, die korrosions- und alterungsstabil sind, keine Ausgasungen zeigen, eine hohe Temperaturbeständigkeit aufweisen und/oder eine ausreichende Haftung auf dem Trägermaterial besitzen. Ein weiteres Kriterium ist die Laminierfähigkeit der entsprechenden Folie, die beim Erweichen und Laminieren während des Aufbringens auf den Chip und den Träger keine Beschädigungen und insbesondere Risse oder Löcher erhalten darf. Geeignet sind insbesondere Folien aus Polyamid- und Polyimid, die eine hohe Thermostabilität aufweisen.

Weitere geeignete Materialien für die Folie sind Duroplaste und Reaktionsharze, beispielsweise Epoxidharze. Wegen der beschränkten Laminiereigenschaften ausgehärteter Duroplaste und Reaktionsharze werden Folien aus solchen Materialien vorzugsweise in einem ungehärteten oder zumindest nichtvollständig ausgehärteten Zustand verwendet. Für Reaktionsharze ist beispielsweise die Technik des Vorhanggießens geeignet, bei dem aus einem flüssigen Polymer, z.B. einem Reaktionsharz, eine dünne Folie durch Gießen auf ein Substrat hergestellt und anschließend auf dem Substrat gehärtet wird. Bei geeignet eingestellter Konsistenz des Reaktionsharzes läßt sich eine solche Schicht wie eine Folie handhaben.

Da die Aufbringung der Folie mit mechanischem Druck auf den Chip und dabei zu einer Verformung der Flip-Chip-Verbindung kommen kann, wird vorteilhaft für die Bumps ein Material hoher Festigkeit gewählt, das beim Aufbringen der Folien keine mechanische Verformung zeigt. Dafür sind insbesondere SnAg, SnAgCu, SnCu, Au oder Leitkleber geeignet. Damit werden unerwünschte und unkontrollierbare Geometrieänderungen des Bauelements während des Verfahrens vermieden.

Zur Strukturierung der aufgebrachten Folie sind verschiedene Techniken geeignet. Möglich ist es beispielsweise, mit Hilfe einer Photolithographie die Bereiche der Folie zu definieren und zu schützen, die auf dem Träger bzw. dem Bauelement verbleiben sollen. Als Strukturierungsmittel kann dann ein naßchemisches oder ein Plasma-Ätzverfahren eingesetzt werden. Möglich ist es jedoch auch, die Strukturierung der Folie direkt vorzunehmen, beispielsweise durch mechanische Schichtabtragungsverfahren oder mittels eines Lasers. Die Strukturierung erfolgt dabei so, daß die Folie in dem Randbereich definierter Breite rund um den Chip, in dem sie auch fest auf dem Träger aufliegt, erhalten bleibt. Die Funktion der Folie als Abdichtung des Bauelementes gegenüber dem Aufbringverfahren der hermetisch abdichtenden Schicht oder als Komponente der gesamten Verkapselung bleibt so erhalten bzw. gewährleistet. Die Folie wird dann außerhalb des Randbereiches zumindest soweit entfernt, daß ringförmig um den Randbereich herum ein ausreichend breiter Oberflächenbereich des Trägers freigelegt wird, um ein dichtes Abschließen der aufzubringenden hermetisch dichten Schicht mit dem Träger zu gewährleisten.

Gemäß der Erfindung wird die Folie nicht nur in einem Streifen, sondern im Bereich von zumindest zwei wesentlich schmaleren Streifen, die im geringen Abstand parallel zum Randbereich diesen umfassen, entfernt. Auf diese Weise wird im Kontaktbereich eine hermetische Abdichtung der hermetisch dichten Schicht zum Träger auf einer wesentlich geringeren Fläche ermöglicht, als bei Verwendung nur eines Streifens. Dadurch wird die zur hermetischen Verkapselung des Bauelementes erforderliche Oberfläche auf dem Träger und damit auch die Größe des gesamten Bauelementes reduziert. Ausreichend ist es, die Streifen mit einer Breite und in einem Abstand zueinander auszubilden, der jeweils ungefähr der Dicke der Folie entspricht. Während bei einem einzigen Kontaktstreifen für die hermetische Schicht zum Träger eine relativ große Streifenbreite vorgesehen wird, sind für die z. B. zwei streifenförmigen Kontaktbereiche nur Breiten von beispielsweise jeweils ca. 35 µm erforderlich, was einen geringeren Flächenbedarf erfordert. Bei Bedarf ist es möglich, die Folie im Bereich von mehr als zwei parallelen Streifen zu entfernen um die Dichtigkeit der hermetischen Schicht bzw. den dichten Abschluß der hermetischen Schicht gegenüber dem Träger weiter zu erhöhen. Damit wird auch eine weiter verbesserte Dichtigkeit der gesamten Verkapselung erhalten.

In einer weiteren Ausgestaltung der Erfindung wird vorgeschlagen, zur Erhöhung der Dichtigkeit der Verkapselung neben der Oberfläche des Trägers auch einen Bereich der Chipoberfläche, insbesondere auf der Rückseite oder umlaufend an den Seitenflächen frei zu legen, um hier einen dichten Kontakt der hermetisch dichtenden Schicht direkt mit dem Chip zu ermöglichen. Auch hierzu kann die partielle Entfernung der Folie in einem streifenförmigen Bereich mit Hilfe einer Lasertechnik erfolgen, wobei der Streifen entweder auf den seitlichen Außenflächen des Chips verläuft und ringförmig geschlossen ist oder auf der Rückseite des Chips angeordnet ist und in der Nähe der Außenkanten des Chips verläuft. Möglich ist es jedoch auch, einen Teil der Rückseite oder die gesamte Rückseite des Chips mit dem verwendeten Strukturierungsverfahren, beispielsweise auch mit einer Photolithographie-Technik freizulegen.

In einer weiteren Ausgestaltung der Erfindung, kann der Chip auf der Rückseite mit zumindest einer Teilmetallisierung versehen werden, vorzugsweise aber ganzflächig metallisiert werden. Auf diese Weise kann eine gut wärmeleitende Verbindung zwischen Chip und hermetisch abdichtender Schicht hergestellt werden, was durch die verwendete Folie allein nicht unbedingt gewährleistet ist. Die Rückseitenmetallisierung kann darüber hinaus mit den Bauelementstrukturen auf der zur Oberfläche des Trägers weisenden Vorderseite des Chips verbunden sein. Auf diese Weise gelingt eine zusätzliche Anschlußmöglichkeit für die Bauelementstrukturen auf der Rückseite des Chips.

Vorzugsweise wird als hermetisch abdichtende Schicht eine Metallschicht aufgebracht. Des Weiteren sind zur Erzeugung einer hermetisch abdichtenden Schicht auch das Aufbringen von anorganischen Materialien geeignet. Die Metallschicht kann insbesondere in einem mehrstufigen Verfahren erzeugt werden, wobei zunächst eine Grundmetallisierung ganzflächig auf Folie und im Kontaktbereich freigelegte Oberfläche des Trägers aufgebracht wird, die in einem anschließenden Schritt verstärkt wird. Vorzugsweise wird zur Erzeugung einer Grundmetallisierung ein Sputter-Verfahren oder ein stromloses Metallabscheidungsverfahren oder eine Kombination beider Verfahren verwendet. Vorteilhaft läßt sich beispielsweise eine Grundmetallisierung durch Sputtern von Kupfer und/oder Nickel erzeugen. Zur stromlosen Abscheidung auf nichtleitenden Oberflächen wie beispielsweise der Folie sind insbesondere Kupferabscheidebäder bekannt. Das stromlose Abscheideverfahren hat außerdem den Vorteil, daß es eine Metallabscheidung auch an solchen Stellen des Bauelementes sicher stellt, die für das Sputtern nicht zugänglich sind. An solchen Stellen könnten mit anderen Verfahren elektrisch nicht leitende Bereiche entstehen, die dann auch nicht mehr verstärkt werden können. Diese Stellen wären dann potentielle Undichtigkeiten für das Bauelement und werden durch die Verwendung der stromlosen Metallabscheidung vermieden. Vorzugsweise wird die stromlose Metallabscheidung nach dem Aufsputtern einer Grundmetallisierung durchgeführt, da insbesondere eine aufgesputterte Titan/Kupferschicht Vorteile bezüglich einer guten Haftung auf der Folie aufweist und eine Diffusion von Feuchte in das Bauelement-Innere während des nachfolgenden naßchemischen bzw. elektrochemischen Prozeßes weitgehend verhindert.

Zur Verstärkung der Grundmetallisierung sind insbesondere galvanische Verfahren geeignet, insbesondere wenn bereits eine durchgängige und dichte Grundmetallisierung vorliegt. Zur galvanischen Verstärkung ist insbesondere die Abscheidung von Kupfer geeignet, die anschließend noch mit einer dünneren Schicht eines korrosionsinhibierenden Metalles abgedeckt wird, beispielsweise mit Nickel oder einem Edelmetall. Möglich ist es jedoch auch, die Metallschicht durch stromlose Abscheidung entweder direkt auf das Bauelement oder auf die Grundmetallisierung bis zur gewünschten Dicke zu erzeugen. Möglich ist es jedoch auch, die Metallschicht mit oder ohne Grundmetallisierung durch Aufdampfen eines Metalls oder durch Inkontaktbringen des Bauelements mit einer Metallschmelze zu erzeugen. Geeignet sind auch Kombinationen der angegebenen Verfahren.

Die Dicke der Metallschicht, die als hermetisch abdichtende Schicht verwendet wird, wird in Abhängigkeit von den gewünschten Eigenschaften gewählt. Eine ausreichende Dichtigkeit wird bereits mit wenigen µm erhalten. Wird die hermetisch abdichtende Schicht bzw. die Metallschicht zur HF Abschirmung von elektronischen Bauelementen verwendet, insbesondere zur Abschirmung von HF Frequenzen arbeitenden Bauelementen, so kann eine höhere Dicke zum Erreichen der gewünschten HF Abschirmung gegen äußere Einflüsse oder zur Abschirmung gegenüber Abstrahlung aus dem Bauelement erforderlich sein. Geeignet sind generell Metallschichten ab einer Dicke von ca. 3 bis 14 µm.

Wird die Metallschicht zur HF-Abschirmung verwendet, so wird sie vorzugsweise mit Masse verbunden. Dies kann dergestalt erfolgen, daß auf dem Träger im Kontaktbereich, der direkt mit der Metallschicht in Kontakt steht, eine Metallisierung vorgesehen ist, die mit dem Masseanschluß des Bauelementes verbunden ist. Beispielsweise kann diese Metallisierung mit einer Durchkontaktierung durch den Träger kontaktiert sein, die wiederum mit Masseanschlüssen auf der Unterseite des Trägers elektrisch leitend verbunden ist. In einer weiteren Ausgestaltung der Erfindung wird die Metallschicht sowohl mit einem elektrischen Anschluß auf dem Träger als auch mit der Chiprückseite verbunden. Dazu ist es erforderlich, die Chiprückseite zumindest im Bereich dieses Kontaktes bei der Strukturierung oder in einem separaten Schritt von der Folie zu befreien, bzw. die Chiprückseite dort vor dem Aufbringen der hermetisch abdichtenden Schicht freizulegen. Hierzu wird ein Chip verwendet, der auf der Chiprückseite eine Metallisierung aufweist. Die elektrische Anbindung dieser Metallisierung über die Metallschicht der hermetisch abdichtenden Schicht mit einem elektrischen Bauelement Anschluß beispielsweise auf der Unterseite des Trägers kann dann zur elektrischen Abstimmung des Bauelementes, insbesondere zur elektrischen Abstimmung eines mit akustischen Wellen arbeitenden Bauelementes, insbesondere eines Filters dienen.

In einer weiteren Ausgestaltung der Erfindung wird direkt auf der Chiprückseite vor oder nach dem Aufbringen der Folie, wenn im letzteren Fall beim Strukturieren die Rückseite des Chips frei gelegt wird, eine Schicht aufgebracht, die zur Dämpfung von Volumenwellen geeignet ist, wobei das Bauelement in diesem Fall ein mit akustischen Oberflächenwellen arbeitendes Bauelement ist. Eine solche Volumenwellen dämpfende Schicht ist akustisch an das Material des Chips angepaßt und weist einen zur Dämpfung geeigneten E-Modul auf. Solche Materialien sind hinlänglich bekannt.

Weiterhin ist zur Erzeugung einer hermetisch abdichtenden Schicht auch das Aufbringen von anorganischen und keramischen Materialien geeignet, beispielsweise Siliziumdioxid, Glas oder Siliziumcarbid. Insbesondere Materialien auf der Basis von Siliziumdioxid und insbesondere Gläser lassen sich in einer Reihe von Dünnschichtverfahren erzeugen bzw. auf beliebige Oberflächen aufbringen. Gläser haben den Vorteil, daß sie auf Grund ihres niedrigen Schmelzpunktes mittels eines Temperschritts erweicht und verdichtet werden können. Durch das Erweichen wird auch ein Verfließen und damit eine gute oberflächenkonforme Flächenabdeckung erzielt.

Zur weiteren Ausgestaltung der erfindungsgemäßen Verkapselung wird vorgeschlagen, auf dem Träger über der hermetisch abdichtenden Schicht noch eine Kunststoffabdeckung aufzubringen, einen sogenannten Glob Top. Dieser wird in zunächst flüssiger aber zumeist viskoser Form ganzflächig auf den Träger über der hermetisch abdichtenden Schicht aufgebracht, vorzugsweise bis zu einer solchen Höhe, daß eine einheitliche Schichtdicke über dem Träger, bzw. eine ebene Oberfläche des gesamten Bauelements erhalten wird. Als Glob Top Abdeckmassen sind insbesondere Reaktionsharze geeignet. Möglich ist es jedoch auch, thermoplastische Pressmassen dazu zu verwenden. Während die Reaktionsharze auch aufgetropft bzw. vergossen werden können, ist zum Aufbringen von Pressmassen eine entsprechende Spritzform erforderlich.

Für den erfindungsgemäß verwendeten Träger ist weiterhin ein mechanisch und elektrisch angepaßtes Material oder eine Kombination solcher Materialien geeignet. Das Trägermaterial weist vorzugsweise ausreichend mechanische Festigkeit auf und ist außerdem hermetisch dicht gegenüber Gasen und Feuchtigkeit. Vorzugsweise wird ein Träger mit mehrschichtigem Aufbau verwendet, welcher auf der Oberfläche Metallisierungen zur Kontaktierung des Bauelements über Bumps aufweist, und der an der Rückseite Anschlußmetallisierungen zum Verbinden mit einer Leiterplatte, insbesondere in SMD Technik besitzt. Zwischen zwei Schichten können Verdrahtungsebenen vorgesehen sein, wobei die Verbindung zwischen den unterschiedlichen Ebenen bzw. den Zwischenebenen und der Ober- und Unterseite des Trägers über Durchkontaktierungen erfolgt. Zur Erhöhung der Dichtigkeit sind alle Durchkontaktierungen von der Oberseite zur Unterseite des Trägers nicht durchgehend und zumindest seitlich gegeneinander versetzt. Für den Träger sind eine Vielzahl von Materialien geeignet, beispielsweise Aluminiumoxid, Glas, HTCC, LTCC oder organische Träger wie beispielsweise PCB oder Folienmaterialien wie Kapton® oder Mylar®. Um bei zunehmender Miniaturisierung der Bauelemente noch eine zuverlässige Kontaktierung zu erreichen, insbesondere beim Flip-Chip-Bonden des Bauelements auf den Träger, ist eine LTCC Keramik von Vorteil, die auf Grund ihres geringen Schwunds beim Brennen eine exakt vorherbestimmte Geometrie der Metallisierungen aufweist. Träger aus organischen Materialien können zwar ebenfalls mit exakter Geometrie hergestellt werden, weisen dafür jedoch eine geringere Dichtigkeit gegenüber Umwelteinflüssen auf.

Ein Träger kann zur Verbindung mit genau einem Chip eingesetzt werden und ist dann vorzugsweise entsprechend den Chipabmessungen dimensioniert. Möglich ist es jedoch auch, einen Träger zur Aufnahme mehrerer Chips vorzusehen, welcher dann entsprechend getrennte bzw. auftrennbare Metallisierungen zum Anschließen der einzelnen Chips aufweist. Nach dem Aufbringen der Chips auf den Träger mittels Flip-Chip-Technik kann das erfindungsgemäße Verfahren zur Verkapselung für alle Bauelemente bzw. für den gesamten Träger auf einmal durchgeführt werden. Abschließend kann der Träger dann in die einzelnen Chips vereinzelt werden, indem der Träger zwischen den Chips aufgetrennt wird. Dies kann beispielsweise mittels Sägen, Brechen oder anderer Trennverfahren erfolgen.

In einer weiteren Ausgestaltung wird die Erfindung zur Verkapselung eines Moduls verwendet. In diesem Fall stellt der Träger das Modulsubstrat dar, auf dem das genannte Bauelement zusammen mit weiteren gleichartigen oder unterschiedlichen Bauelementen aufgebracht ist. Die weiteren Bauelemente können dabei sowohl in Flip-Chip-Technik als auch in SMD Technik auf dem Modul aufgebracht sein. Wesentlich ist jedoch, daß das gesamte Modul durch Abdeckung mit Folie, Strukturierung der Folie und Aufbringen einer hermetisch abdichtenden Schicht verkapselt werden kann. Zur Herstellung solcher Module sind insbesondere LTCC-Keramiken geeignet.

Eine vorteilhafte Anwendung findet das erfindungsgemäße Verfahren zur Verkapselung von Oberflächenwellenbauelementen, deren Bauelementstrukturen einerseits nicht mit zusätzlichen Schichten abgedeckt werden können, die aber andererseits besonders empfindlich gegen Korrosion und andere äußere Einflüsse sind und daher einer hermetischen Verkapselung bedürfen. Darüber hinaus ist bei Oberflächenwellenbauelementen das Bedürfnis zur weiteren Miniaturisierung besonders ausgeprägt, um bei der bevorzugten Anwendung in mobilen Geräten der Telekommunikation eine zusätzliche Volumen- und Gewichtsersparnis zu erreichen. Mit der erfindungsgemäßen Verkapselung wird eine besonders kleine und leichte Verpackung bzw. Verkapselung der Bauelemente, hier der Oberflächenwellenbauelemente, erreicht.

Eine weitere Gruppe empfindlicher Bauelemente, die mit der erfindungsgemäßen Verkapselung zuverlässig und dicht verkapselt werden können, sind Sensoren. Möglich ist es daher auch, optische und insbesondere optoelektronische Bauelemente erfindungsgemäß zu verkapseln. In diesem Fall werden insbesondere lichtdurchlässige Materialien und insbesondere ein lichtdurchlässiger Träger verwendet. Möglich ist es auch, zur Verkapselung von optischen Bauelementen die Rückseite des Bauelements zumindest teilweise von einzelnen oder allen Schichten der Verkapselung freizuhalten.

Im folgenden wird die Erfindung an Hand von Ausführungsbeispielen und der dazugehörigen Figuren näher beschrieben.
Figur 1 zeigt im schematischen Querschnitt ein auf einem Träger Flip-Chip gebondetes Bauelement
Figur 2 zeigt im schematischen Querschnitt das Bauelement mit der darüber aufgebrachten Folie
Figur 3 zeigt das Bauelement im schematischen Querschnitt mit unterschiedlichen streifenförmigen Strukturierungsmöglichkeiten
Figur 4 zeigt das Bauelement in der Draufsicht nach einer streifenförmigen Strukturierung
Figur 5 zeigt das Bauelement in der Draufsicht nach einer variierten Strukturierung
Figur 6 zeigt das Bauelement im schematischen Querschnitt nach dieser Strukturierung
Figur 7 zeigt das Bauelement nach dem Aufbringen der hermetisch abdichtenden Schicht
Figur 8 zeigt im schematischen Querschnitt die Kontaktierung einer Rückseitenmetallisierung auf dem Chip mit der hermetisch abdichtenden Schicht
Figur 9 zeigt im schematischen Querschnitt die elektrische Kontaktierung der hermetischen Schicht mit einem Masseanschluß auf der Unterseite des Trägers
Figur 10 zeigt das Bauelement nach dem Aufbringen einer Glob Top-Kunststoffabdeckung
Figur 11 zeigt ein Bauelement mit einer Volumenwellen dämpfenden Schicht auf der Rückseite des Chips

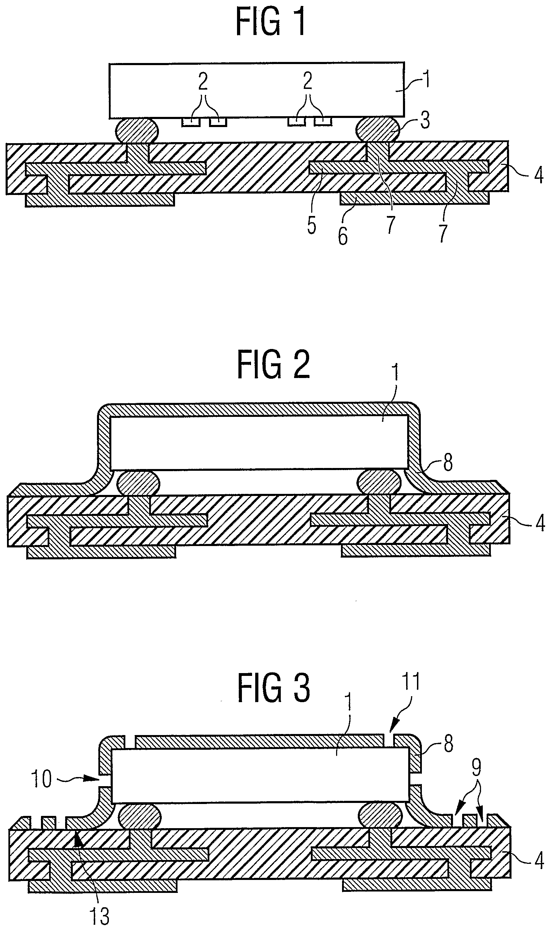

Figur 1 zeigt im schematischen Querschnitt einen Chip 1, der auf seiner Unterseite Bauelementstrukturen 2 trägt, und beispielsweise als Oberflächenwellenbauelement ausgebildet ist. Über Bump-Lötverbindungen 3 ist der Chip 1 mit metallischen Anschlußflächen auf einem Träger 4 verbunden. Der Träger 4 ist hier zweischichtig aufgebaut und weist eine Mehrlagenverdrahtung auf. Die mittlere Metallisierungsebene 5 dient zur Verschaltung und falls erforderlich zur Abdichtung der Durchkontaktierungen 7. Über die Durchkontaktierungen 7 und die Bumps 3 sind die Bauelementstrukturen 2 mit den mit Anschlußmetallisierungen 6 auf der Unterseite des Trägers verbunden. Die Durchkontaktierung 7 durch getrennte Schicht des Trägers sind dabei stets seitlich gegeneinander versetzt, so daß durch den gesamten Träger 4 durchgängige Bohrungen vermieden werden, die potentielle Undichtigkeiten für die hermetische Verkapselung des Bauelements darstellen.

Figur 2: Über die Rückseite des Bauelements 1 und den gesamten Träger 4 wird nun eine aus Kunststoff bestehende Folie 8 aufgebracht und durch Temperaturerhöhung und unter Druck auf die Rückseite des Chips 1 und die sie umgebende Oberfläche des Trägers 4 auflaminiert. Dabei entsteht in einem dem Chip 1 umschließenden Randbereich 13 eine dichte Verbindung der Folie 8 mit der Oberfläche des Trägers 4.

Figur 3 zeigt im schematischen Querschnitt, wie mit Hilfe streifenförmiger Strukturierungen 9 der Kunststoffolie 8 ebenso streifenförmige Bereiche der Trägeroberfläche freigelegt werden.

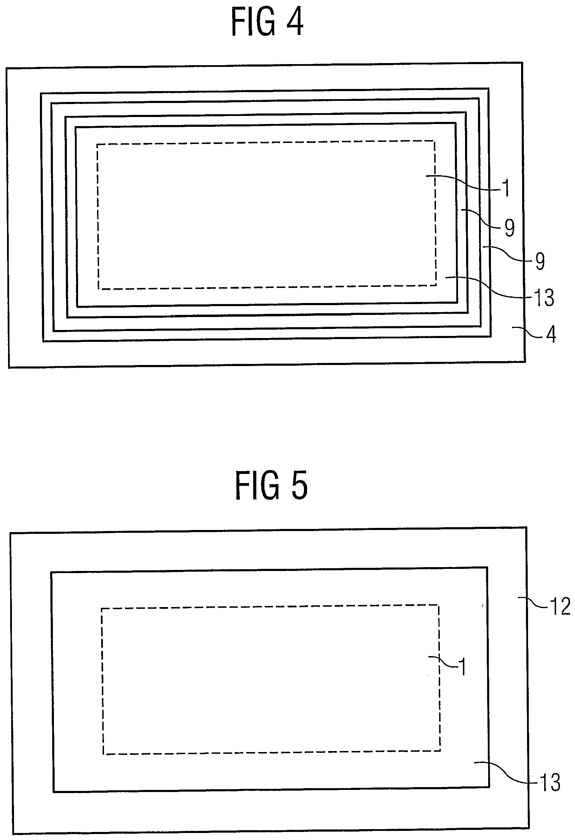

Figur 4 zeigt in schematischer Draufsicht auf den Träger 4 den darauf aufgebondeten Chip 1 und eine beispielhafte Anordnung dieser streifenförmigen Strukturierungen 9. Unter Belassung eines Randbereichs 13 um den Chip 1 verlaufen die streifenförmigen Strukturierungen 9 parallel zur Chipaußenkante bzw. parallel zum Randbereich. In den streifenförmigen Strukturierungen kann die im späteren Verfahrensschritt aufgebrachte hermetisch abdichtende Schicht mit der Oberfläche des Trägers 4 hermetisch abschließen.

In Figur 3 sind weitere Möglichkeiten für streifenförmige Strukturierungen 10 entlang der Seitenwände des Chips 1 und Strukturierungen 11 auf der Rückseite des Chips. Diese können einzeln oder in Kombination ebenfalls dazu dienen, die spätere hermetisch abdichtende Schicht in innigen (hermetischen) Kontakt mit dem Chipkörper zu bringen. Doch wird eine ausreichende hermetische Abdeckung bereits ohne diese zusätzlichen Strukturierungen 10 und 11 erreicht.

Als eine nicht erfindungsgemäße Lösung zeigt Figur 5 in schematischer Draufsicht auf die Oberfläche des Trägers und den Chip 1 eine weitere Möglichkeit, die Folie 8 zu strukturieren. Um den den Chip 1 umgebenden Randbereich 13 herum wird die Folie 8 in einem, beispielsweise 200 µm breiten Streifen entfernt.

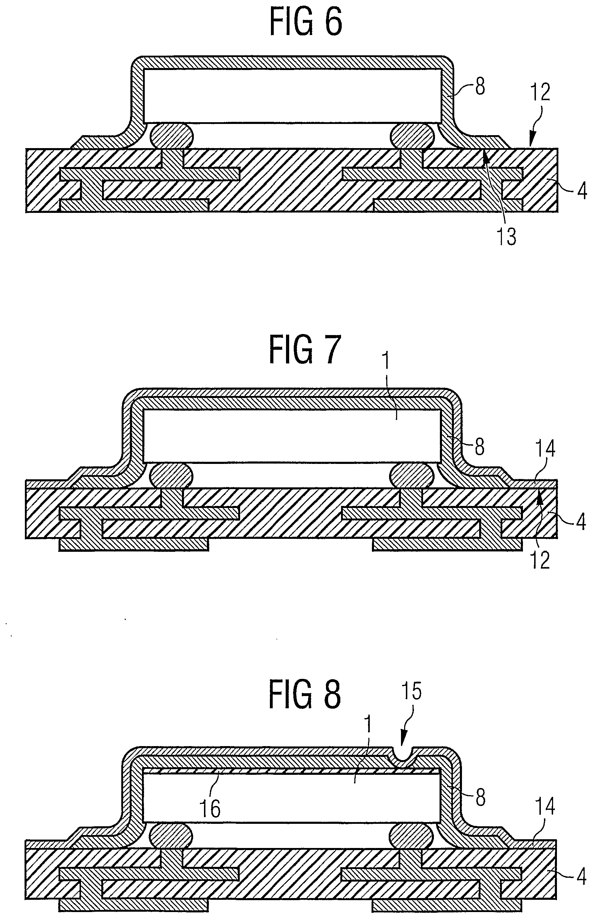

Figur 6 zeigt das Bauelement nach dieser Strukturierungsvariante im schematischen Querschnitt. Der Kontaktstreifen 12 ist nun frei von Folie, im Randbereich 13 dagegen sitzt die Folie dicht auf dem Träger 4 auf.

Auf die nach einem der genannten Verfahren strukturierte Folie 8 wird nun als hermetisch abdichtende Schicht eine Metallschicht 14 aufgebracht. Dazu wird vorzugsweise zunächst eine metallische Grundschicht durch Aufsputtern von Titan und Kupfer erzeugt. Diese Schicht hat beispielsweise eine Dicke von weniger als ein µm. Zur Vermeidung nicht metallisierter Folienbereiche wird die Grundmetallisierung anschließend durch stromlose Abscheidung von beispielsweise Kupfer um ca. 1 bis 12 µm verstärkt. Anschließend kann die stromlos abgeschiedene Metallisierung noch galvanisch verstärkt werden, beispielsweise ebenfalls mit Kupfer. Anschließend wird eine ca. 2 µm dicke Nickelschicht (insbesondere zum RF Shielding) aufgebracht. Vorteilhaft wird die Metallisierung an die thermische Ausdehnung des Trägers angepaßt. Als Ergebnis wird eine hermetisch dichte Metallschicht 14 erhalten, die allseits gut auf der strukturierten Folie 8 aufliegt und die im frei strukturierten Rand 12 (Kontaktbereich) bzw. alternativ in der streifenförmigen Strukturierung 9 in Kontakt mit der Oberfläche des Trägers 4 tritt. Dieser Kontakt bildet um den Chip herum einen hermetischen Abschluß zum Träger 4.

Figur 8 zeigt im schematischen Querschnitt eine weitere Ausgestaltung sinnvoll zum Verstehen der Erfindung, bei der der Chip 1 zumindest in Teilbereichen seiner Rückseite eine Rückseitenmetallisierung 16 aufweist. Beim Strukturieren der Folie 8 wird die Rückseitenmetallisierung 16 zumindest teilweise freigelegt. Im dargestellten Ausführungsbeispiel ist die Rückseitenmetallisierung 16 an der Stelle 15 punkt- bzw. streifenförmig freigelegt. Beim Aufbringen der hermetisch dichten Schicht bzw. der Metallschicht 14 kann diese an der Stelle 15 in elektrisch leitenden Kontakt mit der dort freigelegten Rückseitenmetallisierung 16 treten.

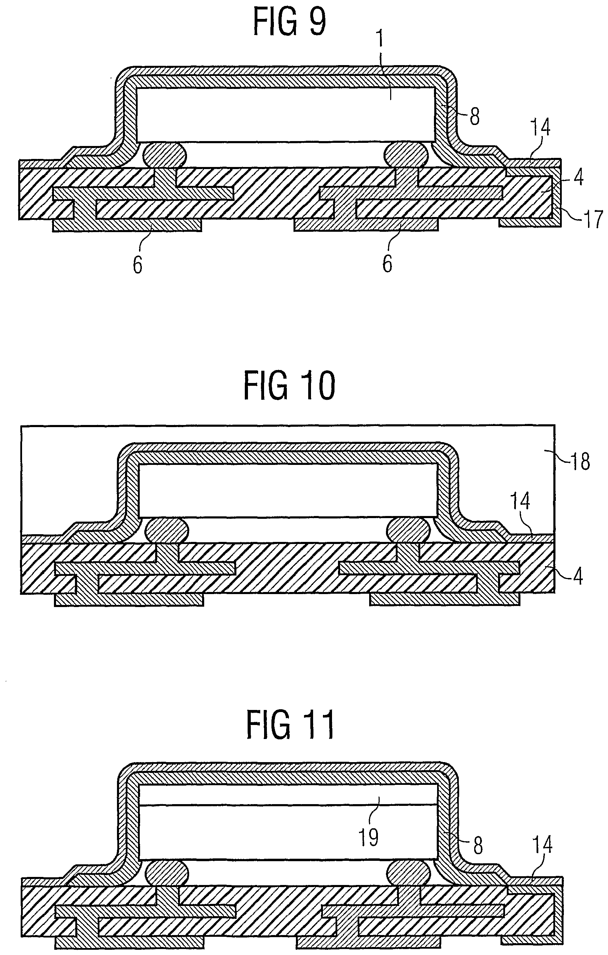

Figur 9 zeigt eine Ausgestaltung, sinnvoll zum Verstehen der Erfindung, bei der die die hermetische Schicht 14 bildende Metallschicht mit einer Metallisierung 17 überlappt und so einen elektrischen Kontakt herstellt. Die Metallisierung 17 ist elektrisch leitend mit einem auf der Unterseite des Trägers 4 ausgebildeten Masseanschluß verbunden. Dadurch ist es möglich, die hermetische Schicht 14 an frei definierbaren Randstellen mit Masse zu verbinden, wodurch eine bessere HF Abschirmung des Bauelements erreicht wird.

Figur 10 zeigt im schematischen Querschnitt eine weitere Ausgestaltung sinnvoll zum Verstehen der Erfindung einer Glob Top-Abdeckung über der hermetisch dichten Schicht. Diese Kunststoffabdeckung 18 ist hier in einer solchen Höhe aufgebracht, daß sie eine ebene Oberfläche parallel zur Oberfläche des Trägers ausbildet. Diese beispielsweise aus Reaktionsharz ausgeführte Abdeckung führt zu einem weiter verbesserten hermetischen Abschluß des Bauelements gegen die Umwelt.

Figur 11 zeigt eine weitere Ausgestaltung sinnvoll zum Verstehen der Erfindung bei der die Folie 8 und die hermetische Abdeckung 14 mit einer Volumenwellen dämpfenden Schicht 19 kombiniert ist. In der dargestellten Ausführung ist die Volumenwellen dämpfende Schicht 19 vor der Aufbringung des Chips auf der Rückseite des Chips aufgebracht. Nicht dargestellt ist die Möglichkeit, über der Volumenwellen dämpfenden Schicht 19 die Folie im Bereich der Rückseite zu entfernen. Möglich ist es auch, die Volumenwellen dämpfende Schicht 19 im Bereich der Rückseite oberhalb der Folie 8, aber unterhalb der hermetisch abdichtenden Schicht 14 aufzubringen, beispielsweise vor der Strukturierung der Kunststoffschicht.

## Patentansprüche

1. Verfahren zur Herstellung einer hermetischen Verkapselung für ein elektronisches Bauelement mit den Schritten:
a) Befestigen und elektrisches Kontaktieren eines auf einem Chip (1) aufgebauten Bauelements auf einem elektrische Anschlußflächen (7) aufweisenden Träger (4) so, daß die Bauelementstrukturen (2) tragende Vorderseite des Chips zum Träger weist und nach der Befestigung im lichten Abstand zu diesem angeordnet ist
b) Überdecken der Rückseite des Chips mit einer Folie (8) aus Kunststoff so, daß die Ränder der Folie den Chip überlappen
c) dichtes Verbinden der Folie (8) mit dem Träger (4) im gesamten Randbereich (13) rund um den Chip
e) Aufbringen einer abdichtenden Schicht (14) aus anorganischen Materialien über der Folie, **dadurch gekennzeichnet, daß** vor Schritt e) Schritt d) durchgeführt wird:
d) Strukturieren der Folie außerhalb des Randbereichs so, daß die Folie im Bereich von zwei Streifen, die im geringen Abstand zueinander parallel zum Randbereich diesen umfassend entfernt wird, wobei die Streifen und deren Abstand zueinander der Dicke der Folie entsprechen, so dass die anschließend aufgebrachte abdichtende Schicht (14) in den streifenförmigen Strukturierungen in einem Kontaktbereich außerhalb des Randbereichs mit dem Träger hermetisch abschließt.

2. Verfahren nach Anspruch 1,
bei dem im Verfahrensschritt b) und c) eine thermoplastische Folie (8) verwendet wird, die den Chip (1) überlappend aufgelegt und unter Druck und erhöhter Temperatur auf die Chiprückseite und den Träger (4) laminiert wird.

3. Verfahren nach Anspruch 1 oder 2,
bei dem im Verfahrensschritt e) zunächst eine Grundmetallisierung auf die Folie (8) und die umgebende Oberfläche des Trägers (4) aufgebracht wird und diese anschließend stromlos und/oder galvanisch verstärkt wird.

4. Verfahren nach Anspruch 1 oder 2,
bei dem im Verfahrensschritt e) zunächst eine Grundmetallisierung stromlos auf die Folie (8) und die umgebende Oberfläche des Trägers (4) aufgebracht anschließend auf die erforderliche Dicke verstärkt wird durch zumindest einen der Schritte Sputtern, Aufdampfen, stromlose Abscheidung, galvanische Abscheidung, Inkontaktbringen mit einer Metallschmelze oder durch eine Kombination der Verfahren.

5. Verfahren nach einem der Ansprüche 1-4,
bei dem die Folie (8) im Verfahrensschritt d) durch Laserablation entfernt wird, wobei die Oberfläche des Trägers (4) oder eine darauf befindlichen Metallisierung (17) frei gelegt wird.

6. Verfahren nach einem der Ansprüche 1-5 bei dem auf der Rückseite des Chips (1) eine Metallisierung (16) erzeugt wird, und bei dem vor dem Aufbringen der hermetisch abdichtenden Schicht (14) die Folie (8) auf der Rückseite im Bereich der Metallisierung (16) zumindest teilweise entfernt wird.

7. Verfahren nach einem der Ansprüche 1-6 bei dem die Folie (8) im Verfahrensschritt b) mittels Vorhanggießens aufgebracht wird.

8. Verfahren nach einem der Ansprüche 1-7,
bei dem außerhalb des Randbereichs (13) auf dem Träger (4) eine mit einem Masseanschluß des Trägers (4) verbindbare Anschlußmetallisierung (17) vorgesehen wird, die mit der hermetisch abdichtenden Schicht (14) überlappt und diese elektrisch kontaktiert.

9. Verfahren nach einem der Ansprüche 1-8,
bei dem nach Verfahrensschritt e) eine Kunststoffabdeckung (18) in zunächst flüssiger Form ganzflächig auf den Träger (4) und die mit der hermetischen Schicht (14) abgedeckte Rückseite des Chips (1) so aufgebracht wird, daß die Kunststoffabdeckung (18) nach dem Erhärten eine annähernd ebene Oberfläche ausbildet.

10. Verfahren nach Anspruch 1-9,
bei dem ein Oberflächenwellen Bauelement verwendet wird und bei dem direkt auf die Rückseite des Chips (1) oder auf die Folie (8) über der Rückseite eine zusätzliche, im Wesentlichen organische und Volumenwellen dämpfende Schicht (19) aufgebracht wird.

11. Verfahren nach einem der Ansprüche 1-10,
bei dem als hermetisch abdichtende Schicht (14) eine anorganische Schicht aufgebracht wird, ausgewählt aus SiO₂, SiC oder Glas.

12. Verfahren nach einem der Ansprüche 1-11,
bei dem zur Strukturierung der Folie (8) eine Photostrukturierung eingesetzt wird.

13. Verfahren nach einem der Ansprüche 1-12,
bei dem der Träger (4) ein Modul ist, auf dem weitere Chips (1) und/oder andere Bauelemente in der genannten Weise aufgebracht, mit dem Träger kontaktiert und gemäß den Verfahrensschritten b) bis e) verkapselt werden.

14. Verfahren nach einem der Ansprüche 1-12,
bei dem mittels der Verfahrensschritte a) bis e) mehrere Chips (1) auf einem gemeinsamen Träger (4) befestigt, kontaktiert und verkapselt werden, und bei dem die Chips anschließend durch Auftrennen des gemeinsamen Trägers zwischen den Chips außerhalb der genannten Randbereiche (13) vereinzelt werden.

15. Verfahren nach einem der Ansprüche 1-14,
bei dem als Träger (4) eine mehrlagige Platte mit lötbaren Metallisierungen auf der dem Chip (1) zugewandten Seite und mit diesen elektrisch leitend verbundenen Anschlussmetallisierungen (6) auf der Rückseite verwendet wird, deren Basismaterial ausgewählt ist aus Aluminiumoxid, Glas, HTCC, LTCC oder einem organischen Polymer.

16. Verfahren nach einem der Ansprüche 1-15,
bei dem für die Bumps ein Material aus der Liste SnAg, SnAgCu,SnCu, Au oder Leitkleber gewählt wird, das beim Aufbringen der Folien (8) keine mechanische Verformung zeigt.

17. Verwendung des Verfahrens nach einem der vorangehenden Ansprüche zur Verkapselung von OberflächenwellenBauelementen.

18. Verwendung des Verfahrens nach einem der vorangehenden Ansprüche zur Verkapselung von Sensoren.

19. Verwendung des Verfahrens nach einem der vorangehenden Ansprüche zur Verkapselung von optischen und zumindest teilweise lichtdurchlässigen Bauelementen, wobei ein Träger aus Glas verwendet wird.

## Claims

1. Method for producing a hermetic encapsulation for an electronic component, having the steps of:
a) mounting and electrical contacting of a component installed on a chip (1) on a carrier (4) having electrical lands (7), in such a way that the front face of the chip bearing component structures (2) points towards the carrier and after mounting is arranged at a clear distance therefrom
b) covering the back face of the chip with a film (8) of plastics, in such a way that the edges of the film overlap the chip
c) sealed bonding of the film (8) with the carrier (4) over the entire marginal zone (13) around the chip
e) application of a sealing layer (14) of inorganic materials over the film,
**characterized in that**, prior to step e), step d) is carried out:
d) patterning of the film outside the marginal zone in such a way that the film is removed in the region of two strips encompassing the marginal zone at a slight distance from one another and parallel to said marginal zone, wherein the strips and their distance from one another correspond to the thickness of the film, such that the subsequently applied layer sealing (14) forms a hermetic seal with the carrier in the strip-shaped pattern elements in a contact region outside the marginal zone.

2. Method according to Claim 1,
in which, in method steps b) and c), a thermoplastic film (8) is used, which is placed in overlapping manner onto the chip (1) and is laminated onto the chip back face and the carrier (4) under pressure and at elevated temperature.

3. Method according to Claim 1 or 2,
in which, in method step e), first of all a metallized base coating is applied to the film (8) and the surrounding surface of the carrier (4) and this is then thickened electrolessly and/or by electroplating.

4. Method according to Claim 1 or 2,
in which, in method step e), first of all a metallized base coating is applied electrolessly to the film (8) and the surrounding surface of the carrier (4) and then thickened to the necessary thickness by at least one of the following steps: sputtering, vapor deposition, electroless deposition, electrodeposition, contacting with a metal melt or by a combination of methods.

5. Method according to one of Claims 1-4,
in which the film (8) is removed in method step d) by laser ablation, wherein the surface of the carrier (4) or a metallized coating (17) located thereon is exposed.

6. Method according to one of Claims 1-5, in which a metallized coating (16) is produced on the back face of the chip (1), and in which, prior to application of the hermetically sealing layer (14), the film (8) on the back face is removed at least in part in the region of the metallized coating (16).

7. Method according to one of Claims 1-6, in which the film (8) is applied in method step b) by means of curtain coating.

8. Method according to one of Claims 1-7, in which a metallized terminal coating (17) connectable with a ground terminal of the carrier (4) is provided on the carrier (4) outside the marginal zone (13), which metallized terminal coating overlaps with the hermetically sealing layer (14) and contacts this electrically.

9. Method according to one of Claims 1-8, in which, after method step e), a plastics cover (18) is applied initially in liquid form over the entire area of the carrier (4) and the back face of the chip (1) covered with the hermetic layer (14), in such a way that the plastics cover (18) forms an approximately planar surface after hardening.

10. Method according to Claims 1-9, in which a surface wave component is used and in which an additional, substantially organic, bulk wave-damping layer (19) is applied directly to the back face of the chip (1) or to the film (8) over the back face.

11. Method according to one of claims 1-10, in which an inorganic layer, selected from SiO₂, SiC or glass, is applied as a hermetically sealing layer (14).

12. Method according to one of Claims 1-11, in which photopatterning is used to pattern the film (8).

13. Method according to one of Claims 1-12, in which the carrier (4) is a module on which further chips (1) and/or other components are applied in the stated manner, contacted with the carrier and encapsulated according to method steps b) to e) .

14. Method according to one of claims 1-12, in which a plurality of chips (1) are fastened to a common carrier (4), contacted and encapsulated by means of method steps a) to e), and in which the chips are then singulated by severing the common carrier between the chips outside the stated marginal zones (13).

15. Method according to one of Claims 1-14, in which a multilayer board is used as carrier (4) which has solderable metallized coatings on the face facing the chip (1) and metallized terminal coatings (6) connected electrically conductively thereto on the back face, the base material of which board is selected from aluminium oxide, glass, HTCC, LTCC or an organic polymer.

16. Method according to one of claims 1-15, in which a material is selected for the bumps from the list SnAg, SnAgCu, SnCu, Au or conductive adhesive which does not exhibit any mechanical deformation on application of the films (8).

17. Use of the method according to one of the preceding claims for encapsulation of surface wave components.

18. Use of the method according to one of the preceding claims for encapsulation of sensors.

19. Use of the method according to one of the preceding claims for encapsulation of optical and at least partly light-transmissive components, wherein a carrier of glass is used.

## Revendications

1. Procédé pour la fabrication d'une encapsulation hermétique pour un composant électronique, présentant les étapes :
a) fixation et contact électrique d'un composant, monté sur une puce (1), sur un support (4) présentant des surfaces de raccordement électrique (7) de manière telle que la face avant, portant les structures de composant (2), de la puce est orientée vers le support et est disposée à une petite distance par rapport à celui-ci après la fixation
b) revêtement de la face arrière de la puce par une feuille (8) en matériau synthétique de manière telle que les bords de la feuille recouvrent la puce
c) liaison étroite de la feuille (8) et du support (4) dans toute la zone de bord (13) autour de la puce
e) application d'une couche d'étanchéité (14) en matériaux inorganiques sur la feuille
**caractérisé en ce qu'**avant l'étape e), l'étape d) est réalisée :
d) structuration de la feuille en dehors de la zone de bord de manière telle que la feuille est éliminée dans la region de deux bandes, qui entourent la zone de bord à une faible distance l'une de l'autre, parallèlement à ladite zone de bord, les bandes et leur distance l'une par rapport à l'autre correspondant à l'épaisseur de la feuille, de telle sorte que la couche d'étanchéité (14) appliquée consécutivement dans les structurations en forme de bande assure une étanchéité hermétique avec le support dans une zone de contact en dehors de la zone de bord.

2. Procédé selon la revendication 1,
dans lequel, dans les étapes de procédé b) et c), une feuille thermoplastique (8) est utilisée, qui est placée de manière à recouvrir la puce (1) et qui est stratifiée sous pression et sous température augmentée sur la face arrière de la puce et sur le support (4).

3. Procédé selon la revendication 1 ou 2,
dans lequel, dans l'étape de procédé e), on applique d'abord une métallisation de base sur la feuille (8) et sur la surface périphérique du support (4) et celle-ci est ensuite renforcée par dépôt autocatalytique et/ou par galvanisation.

4. Procédé selon la revendication 1 ou 2,
dans lequel, dans l'étape de procédé e), une métallisation de base est d'abord appliquée par dépôt autocatalytique sur la feuille (8) et sur la surface périphérique du support (4) et celle-ci est ensuite renforcée à l'épaisseur nécessaire par au moins l'une des étapes pulvérisation, dépôt en phase vapeur, dépôt autocatalytique, dépôt par galvanisation, mise en contact avec une masse fondue métallique ou par une combinaison des procédés.

5. Procédé selon l'une quelconque des revendications 1-4,
dans lequel la feuille (8), dans l'étape de procédé d), est éliminée par ablation par laser, la surface du support (4) ou une métallisation (17) se trouvant sur celle-ci étant mise à nu.

6. Procédé selon l'une quelconque des revendications 1-5,
dans lequel une métallisation (16) est générée sur la face arrière de la puce (1) et dans lequel, avant l'application de la couche (14) d'étanchéité hermétique, la feuille (8) sur la face arrière est éliminée au moins partiellement dans la zone de la métallisation (16).

7. Procédé selon l'une quelconque des revendications 1-6,
dans lequel la feuille (8) est appliquée, dans l'étape de procédé b), au moyen d'un rideau d'enduction.

8. Procédé selon l'une quelconque des revendications 1-7,
dans lequel on prévoit, en dehors de la zone de bord (13), sur le support (4), une métallisation de raccordement (17) pouvant être reliée à une borne de masse du support (4), qui recouvre la couche (14) d'étanchéité hermétique et qui est en contact électrique avec celle-ci.

9. Procédé selon l'une quelconque des revendications 1-8,
dans lequel, après l'étape de procédé e), un recouvrement en matériau synthétique (18) est appliqué, d'abord sous forme liquide, sur toute la surface du support (4) et sur la face arrière de la puce (1) revêtue par la couche hermétique (14), de manière telle que le recouvrement en matériau synthétique (18) forme une surface quasiment plane après le durcissement.

10. Procédé selon la revendication 1-9, dans lequel un composant à ondes de surface est utilisé et dans lequel une couche (19) supplémentaire, essentiellement organique et atténuant les ondes volumiques, est appliquée directement sur la face arrière de la puce (1) ou sur la feuille (8) sur la face arrière.

11. Procédé selon l'une quelconque des revendications 1-10,
dans lequel on applique, comme couche (14) d'étanchéité hermétique, une couche inorganique choisie parmi le SiO₂, le SiC ou le verre.

12. Procédé selon l'une quelconque des revendications 1-11,
dans lequel une photostructuration est utilisée pour la structuration de la feuille (8).

13. Procédé selon l'une quelconque des revendications 1-12,
dans lequel le support (4) est un module, sur lequel d'autres puces (1) et/ou d'autres composants sont appliqués, mis en contact avec le support et encapsulés selon les étapes de procédé b) à e) de la manière mentionnée.

14. Procédé selon l'une quelconque des revendications 1-12,
dans lequel, au moyen des étapes de procédé a) à e), plusieurs puces (1) sont fixées, mises en contact et encapsulées sur un support (4) commun et dans lequel les puces sont ensuite individualisées par séparation du support commun entre les puces en dehors des zones de bord (13) mentionnées.

15. Procédé selon l'une quelconque des revendications 1-14,
dans lequel on utilise, comme support (4), une plaque multicouche pourvue de métallisations pouvant être soudées sur la face orientée vers la puce (1) et de métallisations de raccordement (6) reliées de manière électriquement conductrice à celle-ci sur la face arrière, dont le matériau de base est choisi parmi l'oxyde d'aluminium, le verre, HTCC, LTCC ou un polymère organique.

16. Procédé selon l'une quelconque des revendications 1-15,
dans lequel, pour les bosses, on choisit un matériau dans la liste formée par SnAg, SnAgCu, SnCu, Au ou une colle conductrice, qui ne présente pas de déformation mécanique lors de l'application des feuilles (8).

17. Utilisation du procédé selon l'une quelconque des revendications précédentes pour l'encapsulation de composants à ondes de surface.

18. Utilisation du procédé selon l'une quelconque des revendications précédentes pour l'encapsulation de capteurs.

19. Utilisation du procédé selon l'une quelconque des revendications précédentes pour l'encapsulation de composants optiques et au moins partiellement transparents à la lumière, un support en verre étant utilisé.
